# EUROPEAN PATENT SPECIFICATION

(11) **EP 1 643 257 B1**
(45) Date of publication and mention of the grant of the patent: **01.10.2008**
(21) Application number: 04747555.3
(22) Date of filing: 08.07.2004
(51) Int. Cl.: G01R 31/3185

(54) **SCAN TEST DESIGN METHOD, SCAN TEST CIRCUIT, SCAN TEST CIRCUIT INSERTION CAD PROGRAM, LARGE-SCALE INTEGRATED CIRCUIT, AND MOBILE DIGITAL DEVICE**
SCAN-TEST-DESIGN-VERFAHREN, SCAN-TEST-SCHALTUNG, SCAN-TESTSCHALTUNGSEINFÜGE-CAD-PROGRAMM, HOCHINTEGRIERTE SCHALTUNG UND MOBILE DIGITALE EINRICHTUNG
PROCEDE DE CONCEPTION D'ESSAI D'EXPLORATION, CIRCUIT D'ESSAI D'EXPLORATION, PROGRAMME DE CAO D'INSERTION DE CIRCUIT CORRESPONDANT, CIRCUIT INTEGRE A GRANDE ECHELLE, ET DISPOSITIF MOBILE NUMERIQUE

(30) Priority: 09.07.2003 JP 2003272403
(43) Date of publication of application: 05.04.2006
(73) Proprietor: MATSUSHITA ELECTRIC INDUSTRIAL CO., LTD., Kadoma-shi, Osaka 571-8501 (JP)
(72) Inventor: HOSHAKU, Masahiro, Matsushita Elec. Ind. Co. Ltd., Chuo-ku Osaka-shi Osaka 540-6319 (JP)
(74) Representative: Grünecker, Kinkeldey, Stockmair & Schwanhäusser Anwaltssozietät
(86) International application number: PCT/JP2004/010089
(87) International publication number: WO 2005/006004

(56) References cited:
- EP-A- 0 319 187
- EP-A- 0 809 199
- JP-A- 2 061 569
- JP-A- 10 104 320
- US-A- 5 715 171
- US-B1- 6 199 183
- US-B1- 6 502 222
- PATENT ABSTRACTS OF JAPAN vol. 014, no. 240 (P-1051), 22 May 1990 (1990-05-22) -& JP 02 061569 A (MATSUSHITA ELECTRIC IND CO LTD), 1 March 1990 (1990-03-01)

## Description

### TECHNICAL FIELD

The present invention relates to an LSI design method, an LSI test circuit and an LSI design CAD program. More particularly, the present invention relates to a design-for-testability technology that secures design guarantee on the hold time in the operation of a shift register that may cause a problem at the time of design of a scan test circuit and suppresses increase in circuit area, power consumption and leak current that may occur with insertion of hold guarantee delay elements.

### BACKGROUND ART

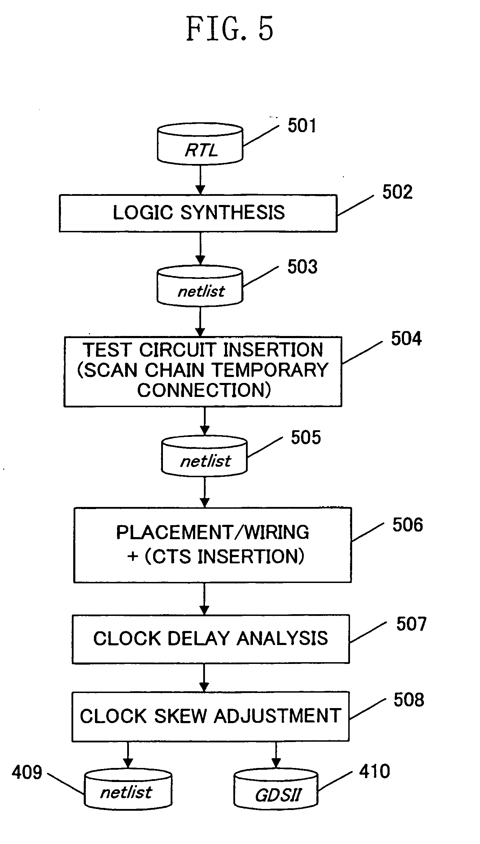

Conventionally, design for testability involves scan test design most commonly. The scan test design will be described with reference to FIG. 5.

Referring to FIG. **5****,** after RTL design, a logic synthesis CAD program **502** is executed for an RTL file **501** as input data to generate a gate-level netlist **503.** Flipflop (FF) circuits constituting part of the resultant gate-level circuit **503** are first replaced with scan FF circuits under a scan test circuit insertion CAD program **504.** Each of the scan FF circuits has normal data input terminal D and a test input terminal DT as its input terminals, so that data input via the DT terminal is selected if a scan shift mode is set, and data input via the D terminal is selected if a test mode (non-scan shift mode) is set. The scan test circuit insertion CAD program **504** then cascades an output terminal NQ (or Q) of a scan FF circuit to the test input terminal DT of another scan FF circuit. As a result, a plurality of cascaded scan FF circuits operate as a huge shift register, generating a scan test circuit inserted netlist **505.**

In testing of the circuit, data for testing prepared with an automatic test pattern generation (ATPG) program is input in series into the scan shift register via an external scan-in terminal, to allow the data to shift in the shift register. The mode is then switched to the test mode to execute normal data transfer between the FF circuits. Thereafter, the shift register operation is again executed, to allow the data to be output via an external scan-out terminal. The output data is checked against an expected value to thereby perform LSI fault examination.

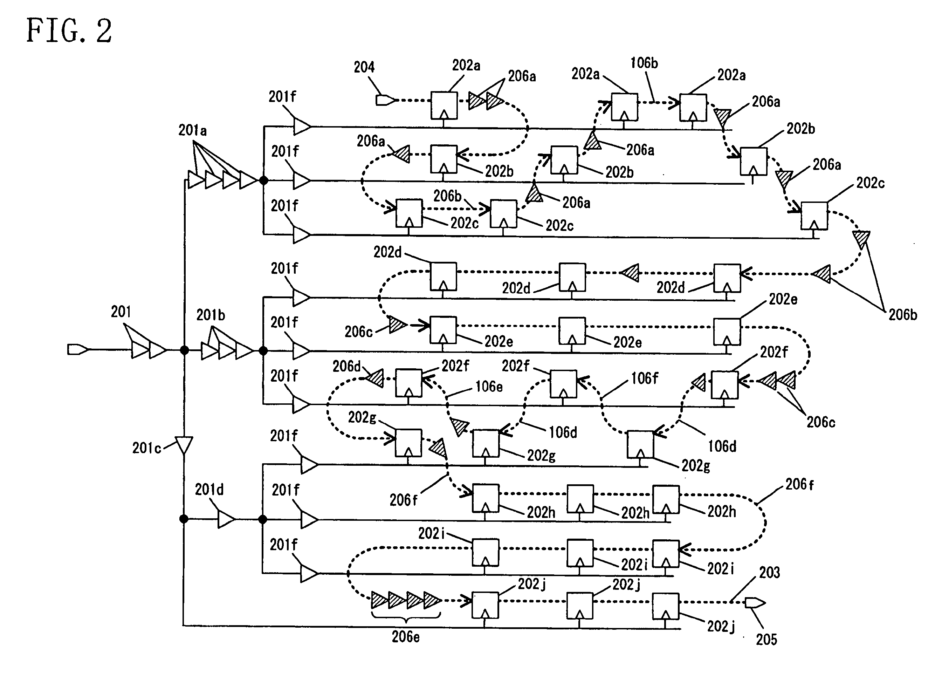

In the conventional scan test design described above, the connection between DT input terminals and Q output terminals of scan FF circuits is randomly determined. In other words, no specific designation is made in design on from which FF circuit to which FF circuit data should be shifted. As a result, a circuit obtained by the conventional scan design has a configuration as shown in FIG. **2****,** for example. In the example of FIG. **2****,** shift data transfer of FF circuit **202a** → FF circuit **202b** and even shift data transfer between different clock tree lines such as FF circuit **202b** → FF circuit **202c** → FF circuit **202d** and circuit **202f** → FF circuit **202g** → FF circuit **202h** occur in some portions.

In a circuit obtained by the conventional scan design described above, buffers for delay insertion are placed at predetermined positions to reduce clock skew, as described in Japanese Laid-Open Patent Publication No. 11-108999.

Unites States Patent US-B-6,199,183 discloses a method for forming a scan path network, wherein a clock is provided via clock buffers to scan flip-flops which are grouped to sub-chains. Sub-chains with long clock path delay times are connected to each other first. In the same manner, European Patent Application EP-A-0 809 199 discloses a method of eliminating scan hold time failures of a scan chain by reordering sequential circuit elements within element groups according to a clock skew of the clock signal, or by analogous ordering of the groups with respect to each other. Elements/groups with long clock skew are connected first. However, both methods require an additional determination of the clock skews.

Unites States Patent US-A-5,715,171 further discloses a logical synthesizing device/method for generating a net list from a feedback loop added flip-flop.

### Problems to be solved

In attaining operation guarantee for the scan shift register by the conventional design method described above, since shift data transfer between different clock tree lines occur in many places as exemplified in FIG. 2**,** a number of delay elements **206a** to **206e** for hold guarantee must be inserted in such scan shift circuit portions between different clock tree lines. This disadvantageously increases the circuit area, the power consumption and the leak current during standby of a number of delay elements.

Moreover, in the conventional circuit in which FF circuits of different clock tree lines are connected to each other, as in the example of FIG. **2****,** when design adopts a semiconductor microfabrication process, which is significantly susceptible to interference such as crosstalk and IR drop, the delay time in the clock tree portion will be affected by such interference and IR drop, resulting in further need for a hold margin in shift data transfer, and thus additional increase in the number of delay elements inserted in the scan shift circuit portion. This additional increase in the number of delay elements resulting from the design for testability described above will further increase the LSI circuit area and moreover lead to increase in power consumption and significant increase in leak current during standby of a number of delay elements.

### DISCLOSURE OF THE INVENTION

An object of the present invention is providing a scan test design method and a scan test circuit in which the number of delay elements inserted in a scan shift circuit is effectively reduced even under a conspicuous influence of crosstalk and IR drop that will occur significantly in a large-scale integrated circuit adopting a microfabrication process, to thereby ensure operation guarantee for a scan shift register while reducing the area of the large-scale integrated circuit and effectively suppressing the power consumption and the off-leak current.

This object is achieved with a scan test design method according to claim 1, a scan test circuit according to claim 7, a scan test circuit insertion CAD comprising computer program code means according to claim 13, a large-scale integrated circuit according to claim 14 and a portable digital equipment according to claim 15. Preferred embodiments are described in the dependent claims.

To solve the problems described above, systematic examination was newly done on the connection relationship among a plurality of scan flipflop (FF) circuits, that is, on from which scan FF circuits to which scan FF circuits data should be transferred, to attain reduction in the number of delay elements to be inserted.

From the above examination, according to the present invention, a scan shift register is formed from a plurality of flipflop circuits driven with each of the final-stage elements of clock tree synthesis (CTS) as one group. A plurality of thus-formed scan shift registers, each serving as a sub-scan chain, may be connected to one another, to constitute a larger scan shift register. In such a case, the sub-scan chains can be connected in the following manner.
(1) Shift registers equal in the number of gate stages in the clock line are connected to each other.
(2) In connection of shift registers different in the number of stages, priority is given to connection between those smaller in the difference in the number of stages.
(3) In connection of shift registers different in the number of stages, connection is made so that data be transferred from a sub-chain larger in the number of stages toward a sub-chain smaller in the number of stages, or from a sub-chain larger in clock delay toward a sub-chain smaller in clock delay.

As described above, according to the present invention, a scan shift register is formed from a plurality of flipflop circuits driven with each of the final-stage elements of the clock tree. Since these flipflop circuits have roughly the same propagation delay time of the clock signal to the flipflop circuits, design guarantee for the operation of the scan shift register can be easily obtained.

In the conventional method in which a position of occurrence of data hold violation cannot be specified at the time of insertion of a scan test circuit but only be specified later at the time of timing design, and a hold guarantee delay element is then inserted at the violation position, a number of hold guarantee delay elements must be inserted on the output side of the scan flipflop circuits. Therefore, such hold guarantee delay elements may make transition unnecessarily even during normal operation other than the scan test operation, disadvantageously causing increase in power consumption. According to the present invention, in which the number of hold guarantee delay elements inserted in the shift data transfer line can be reduced, low power can be realized. Moreover, since the leak current (off-leak current) during standby of the delay elements can be reduced, further low power can be realized.

In the conventional method in which hold guarantee delay elements are inserted after finding of hold violation as described above, even when the timing characteristic between flipflop circuits once satisfies the design constraints, the timing characteristic of the entire circuit may be deteriorated if hold violation occurs in the data shift circuit after insertion of the scan test circuit. According to the present invention, only the least number of hold guarantee delay elements can be inserted in the scan shift circuit, and also the circuit is configured to be less likely to cause hold violence at the subsequent timing design. Therefore, with little design reversion and improvement in the convergence of the timing characteristic, short-TAT design is permitted.

In carrying out of a fabrication test using the resultant scan test circuit, since it is possible to attain robust design that can guarantee scan shift operation satisfactorily even if a delay characteristic in the clock circuit occurs at a local position on the chip plane due to a variation in fabrication process, interference such as crosstalk, IR drop or the like, the fabrication yield at the scan test improves.

In particular, according to the present invention, in which the highest priority is given to connection of sub-scan chains equal in the number of stages of elements constituting the clock tree, and connection of sub-scan chains smallest in the relative difference in the number of stages of elements, design guarantee for the shift register operation of the scan test circuit can be obtained satisfactorily even if the propagation delay characteristic of the clock line varies locally due to a fabrication variation, interference such as crosstalk, or IR drop.

In addition, in the scan test circuit insertion CAD program of the present invention, which has a design algorithm of connecting a plurality of scan flipflop circuits driven with each of final-stage elements of the clock tree in series to form a scan shift register, insertion of the scan test circuit can be made automatically. Also, the design algorithm can be used at the same design stage as the conventional scan chain wiring optimization function. This makes it possible to design a semiconductor integrated circuit with no increase in the number of design stages and little design reversion.

Since the scan test circuit to be incorporated is a low-power circuit small in off-leak current and low in power consumption, digital equipment having a long battery life can be implemented by applying the present invention to battery-driven portable digital equipment and car-mounted digital equipment.

### BRIEF DESCRIPTION OF THE DRAWINGS

FIG. **1** is a view showing a scan test circuit having a configuration of a scan shift register in the first embodiment of the present invention.
FIG. **2** is a view showing a scan test circuit having a conventional scan shift register configuration.
FIG. **3** is a conceptual view showing a procedure of connecting sub-scan chains different in the number of stages of elements of a clock tree to each other in the fourth embodiment of the present invention.
FIG. **4** is a design flowchart demonstrating a scan test design method in the sixth and ninth embodiments of the present invention.
FIG. **5** is a conventional test design flowchart.
FIG. **6A** is a view showing a distribution of clock skew in the sixth embodiment of the present invention, and FIG. **6B** is a view showing a method of connection between sub-scan chains that have the clock skew distribution of FIG. **6A** and are different in the number of stages of elements of a clock tree.
FIG. **7** is a view showing a configuration of a scan FF circuit in the seventh embodiment of the present invention.
FIG. **8** is a design flowchart demonstrating a method of scan chain connection using an inter-sub-scan chain clock delay distribution in the eighth embodiment of the present invention.
FIG. **9** is a flowchart showing details of test circuit insertion design in the design flowchart shown in FIG. **8****.**
FIG. **10** is a flowchart showing details of scan chain optimization in the design flowchart shown in FIG. **8****.**
FIG. **11** is a view illustrating the procedure of connection of sub-scan chains according to the flowchart of the test circuit insertion design in FIG. **9****.**
FIG. **12** is a view illustrating a procedure of connection of sub-scan chains according to the flowchart of the scan chain optimization design in FIG. **10****.**
FIG. **13** is a view showing a scan test circuit having a configuration of a scan shift register in the tenth embodiment of the present invention.

### BEST MODE FOR CARRYING OUT THE INVENTION

Hereinafter, embodiments of the present invention will be described with reference to the relevant drawings.

### (First Embodiment)

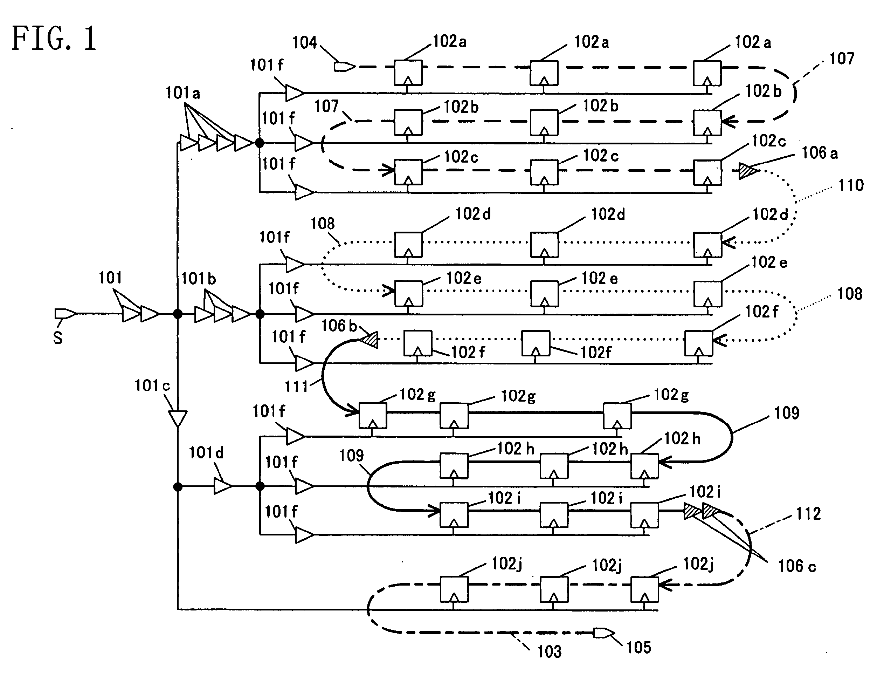

FIG. **1** shows a configuration of a scan shift register of a scan shift circuit implemented by a design-for-testability method of the first embodiment of the present invention, illustrating in particular the configuration of CTS buffers and the connection relationship in the scan shift register. This embodiment will be described with reference to FIG. **1****.**

Referring to FIG. 1, the reference numeral **101** denotes clock delay adjusting buffers and **101a** to **101f** denote CTS buffers. A clock tree T includes branching from a predetermined clock origin point or clock supply point S to the buffers **101a, 101b** and **101c** via the buffers **101,** and each branch is further branched to three buffers **101f.** A clock signal is supplied to clock terminals of a plurality of flipflop (FF) circuits **102a** to 102j via the clock tree T.

In the design method of this embodiment, first, a scan shift register is formed from a plurality of FF circuits driven with each of the final-stage elements **101f** of CTS as the minimum unit. In FIG. **1****,** therefore, the minimum unit of the scan shift register is formed using the three FF circuits **102a.** Likewise, a scan shift register is formed by connecting in series the three FF circuits for each of the FF circuits **102b, 102c, 102d, 102e, 102f, 102g, 102h, 102i** and **102j.**

In this embodiment, the minimum unit of the scan shift register is called a sub-scan chain. The FF circuits in the sub-scan chain constitute an FF circuit group smallest in clock skew in view of the nature of CTS design. Therefore, stable shift operation is expected for such a scan shift register composed of FF circuits driven with the same CTS buffers.

In the event that the influence of interference such as crosstalk, IR drop and the like becomes conspicuous in a microfabrication process, a defect in data shift due to hold time violation in particular will cause a problem. A cause of this trouble is that the clock delay varies with crosstalk, IR drop and the like. In this embodiment, in which each sub-scan chain is a group of FF circuits driven with the same CTS buffers, such a variation of the clock delay affects these FF circuits roughly equally. Accordingly, a scan shift register ensuring stable operation guarantee against the influence of the delay variation described above can be provided.

### (Second Embodiment)

The second embodiment of the present invention will be described.

In FIG. **1** showing the first embodiment described above, a sub-scan chain was formed from the three FF circuits **102a**. A scan shift register was also formed using the three FF circuits for each of the FF circuits **102b, 102c, 102d, 102e, 102f, 102g, 102h, 102i** and **102j,** as in the case of the three FF circuits **102a.** In the first embodiment, therefore, a scan test circuit can be formed by connecting the inputs/outputs of the shift registers to scan inputs/outputs of the LSI. This configuration however requires a huge amount of test terminals in a large-scale circuit, causing increase in test cost and shortage of terminals due to limitations on the external terminals of the LSI. As a result, it may be difficult to implement the design for testability.

To solve the above problem, in this embodiment, the sub-scan chains described in the first embodiment are connected to each other to form a larger scan shift register, to thereby reduce the scan input/output terminals.

To state specifically, among the sub-scan chains described with reference to FIG. 1, the highest priority is given to connection between sub-scan chains equal in the number of stages of CTS buffers via an inter-sub-scan chain connection net **107, 108** or 109. In this connection between sub-scan chains, an arbitrary number of buffers may be inserted for hold time guarantee in consideration of the design margin. In particular, in the event that the clock delay varies in each sub-scan chain under the influence of interference such as crosstalk, IR drop and the like, the clock variation will be different between the sub-scan chains. Therefore, it is desirable to insert a hold guarantee buffer considering this variation. Note that the insertion of a buffer is not necessary required because in some cases the line length is sufficiently long in the connection between the sub-scan chains. In the circuit example of FIG. **1****,** insertion of a delay element for hold time guarantee can be omitted in the inter-sub-scan chain connection nets **107, 108** and **109.** The FF circuits are therefore connected directly without intervention of such a delay element.

As described above, in this embodiment, the sub-scan chains equal in the number of stages of CTS buffer are connected to each other. This reduces the number of scan chains in the LSI, and thus can solve the problem of shortage of scan test terminals.

### (Third Embodiment)

The third embodiment of the present invention will be described.

The third embodiment is directed to a design method to be adopted when the number of scan test terminals (scan-in terminals and scan-out terminals) yet fails to fall within the limitation on the number of terminals even in the second embodiment described above.

When the limitation on the number of scan test terminals is not yet cleared in the second embodiment or when further reduction in the number of scan chains is desired for other reasons, it becomes necessary to connect scan shift registers different in the number of stages of CTS buffers to each other. In this case, as in the second embodiment, the first priority is given to connection of shift registers equal in the number of stages of CTS buffers in series via the inter-sub-scan chain connection net **107, 108** or **109.**

Subsequently, the second priority is given to connection between shift registers smallest in the relative difference in the number of stages of buffers from the clock supply point S through the CTS buffers, that is, shift registers different by one stage in the number of stages, via a connection net **110** or **111.** In FIG. 1, one delay element **106a** or **106b** is inserted in the connection net **110** or **111** because the difference in the number of stages is one.

When still further reduction in the number of scan shift chains is desired, the third priority is given to connection between sub-can chains different by up to two stages in the number of stages of CTS buffers via an inter-sub-scan chain connection net **112.** In this case, two delay elements **106c** are inserted in the connection net **112** because the difference in the number of stages is two. Thereafter, by use of a similar manner of giving higher priority to connection between shift registers smaller in the relative difference in the number of stages of CTS buffers, test design is performed to have scan shift chains of the number conforming to the design requirement specifications or design constraints. FIG. 1 shows an example of the scan test circuit configured by use of this method to finally give one scan chain **103**. In the connection between sub-scan chains different in the number of stages of CTS buffers, a larger number of buffers are inserted in the connection portion larger in the relative difference in the number of stages, while a smaller number of buffers are inserted in the connection portion smaller in the relative difference in the number of stages. The number of buffers to be inserted should be determined in advance for each relative difference in the number of stages.

### (Fourth Embodiment)

The fourth embodiment of the present invention will be described.

In the second and third embodiments, the number of delay elements **106a** to **106c** to be inserted for hold time guarantee should be determined in advance in consideration of the design margin. In this regard, when sub-scan chains having a relative difference in the number of stages of CTS buffers among them and yet having various differences in the number of stages are directly connected to one another, as in the third embodiment in particular, over-margin design may possibly occur in the number of delay elements to be inserted in consideration of combination errors.

To solve the above problem, in the fourth embodiment, the following method is adopted. That is, the first priority is given to connection between shift registers equal in the number of stages of elements constituting the clock tree, as in the design method of the second embodiment described above. Thereafter, if further serial connection is necessary to provide a larger scan shift register, the following second priority, different from the second priority described in the third embodiment, is adopted.

That is, in the fourth embodiment, the following design method is adopted as the design rule for connecting sub-scan chains different in the number of elements of the clock circuit (for example, the number of CTS buffers) to each other. A sub-scan chain largest in the number of stages of CTS buffers is placed on the side of the scan-in terminal, while a scan shift register smallest in the number of stages of elements constituting the clock circuit is placed on the side of the scan-out terminal. Sub-scan chains connected between the sub-scan chain at the next stage on the side of the scan-in terminal and the sub-scan chain at the preceding stage on the side of the scan-out terminal are arranged in the descending order of the number of stages of CTS buffers from the side of the scan-in terminal toward the side of the scan-out terminal.

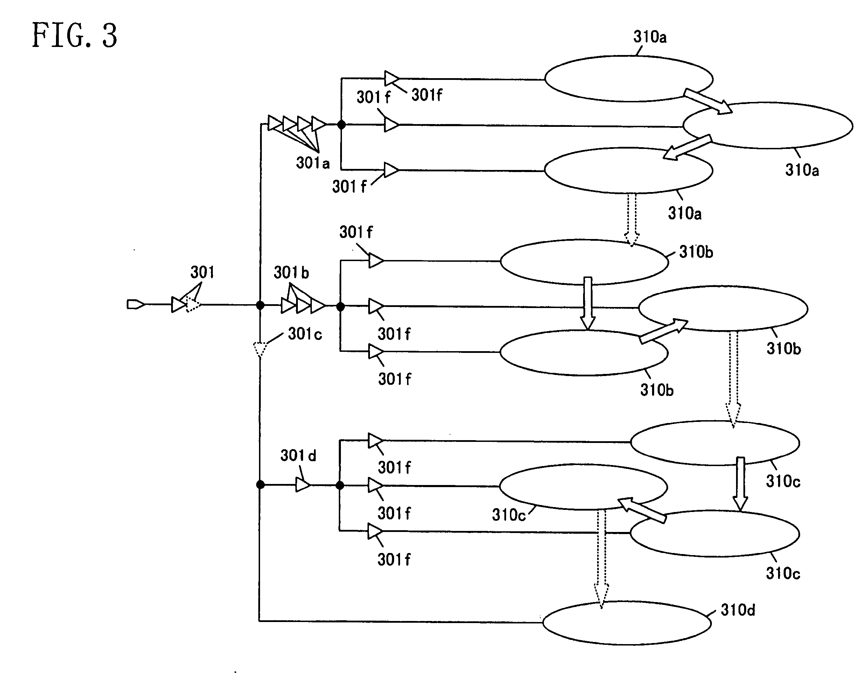

In other words, the scan test circuit configured by the design method described above is a scan test circuit conducting transfer between FF circuits equal in the number of stages of CTS buffers or shift operation from an FF circuit larger in the number of stages of CTS buffers toward an FF circuit smaller in the number of stages of CTS buffers (that is, in the order allowing data transfer from the side larger in the delay time of the supplied clock signal toward the side smaller in the delay time). To state specifically, in FIG. 3, the connection is first made between sub-scan chains **310a** equal in the number of stages of CTS buffers, that is, seven stages, between sub-scan chains **310b** equal in the number of stages of CTS buffers, that is, six stages, and between sub-scan chains **310c** equal in the number of stages of CTS buffers, that is, five stages. Thereafter, the resultant sub-scan chains are connected together so that data transfer be made from the sub-scan chains **310a** large in the number of stages of CTS buffers to the sub-scan chains **310b** and to the sub-scan chains **310c** smaller in the number of stages of CTS buffers, and then to a sub-scan chain **310d** smallest in the number of stages of CTS buffers.

It is generally expected that a shift register large in the number of stages of CTS buffers is often slow in clock delay and a shift register small in the number of stages of CTS buffers is fast in clock delay. Therefore, in data transfer between sub-scan chains different in the number of stages of CTS buffer, data is transferred from an FF circuit slightly slow in clock delay to an FF circuit slightly fast in clock delay, and this results in reducing the margin of the setup time but ensuring safety design for the hold time. In a scan test circuit, in which no circuit is generally formed between FF circuits in the data shift circuit portion, there is enough room for the setup time. However, since no gate exists between FF circuits in the data shift circuit, a problem may arise in guarantee of the hold time in the scan shift register. In the fourth embodiment, a circuit configuration securing room for the hold time can be easily provided. Accordingly, in the fourth embodiment, a robust shift register against a variation in clock delay that may occur under the influence of interference such as crosstalk and IR drop can be obtained.

Moreover, in the fourth embodiment, because safety design is ensured against a variation in clock delay, no over-margin design is necessary for the number of delay elements for hold guarantee to be inserted in the data lines between sub-scan chains different in the number of stages of elements constituting the clock circuit, and thus the design precision increases. Therefore, the number of delay elements can be advantageously reduced compared with the conventional scan test circuit.

### (Fifth Embodiment)

The fifth embodiment of the present invention will be described.

In the second, third and fourth embodiments described above, since the number of delay elements inserted for hold guarantee can be reduced compared with the conventional scan test circuit, the circuit area can also be reduced. In the fifth embodiment, provided is a design method in which further increase in circuit area is suppressed.

Although the basic circuit design method is substantially the same as that in the second, third and fourth embodiments, for example, this embodiment has the following feature. In FIG. **1****,** for example, the delay elements **106a** to **106c** inserted in the inter-sub-scan chain connection nets **110** to **112** at the connections between the sub-scan chains are composed of transistors higher in threshold voltage than transistors constituting the FF circuits **102a** to **102f** and logic circuits. This permits attainment of a large delay time with a small number of delay elements. In other words, the fifth embodiment provides a method of forming the delay elements from high-threshold transistors compared with the threshold voltages of transistors constituting the entire LSI.

### (Sixth Embodiment)

The sixth embodiment of the present invention will be described.

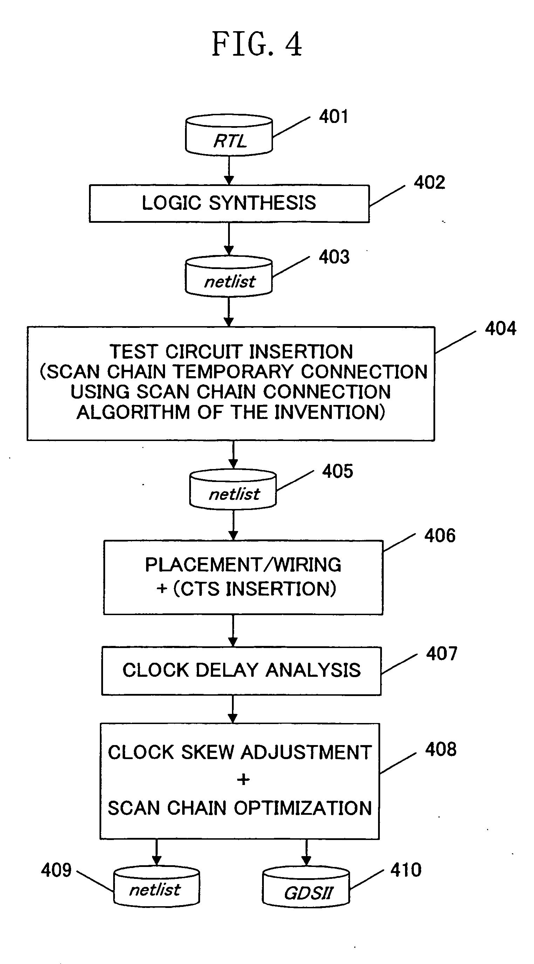

In the fourth embodiment described above, the order of connection among sub-scan chains was determined based on the number of stages of elements constituting the clock circuit. In the sixth embodiment, described is a design method in which the connection between scan chains is optimized in the process of adjusting the clock delay after the CTS insertion, to thereby provide a method of implementing a high-precision scan test circuit. The method will be described with reference to FIGS. **4****,** **5** and **6****.**

FIG. **5** shows a conventional general LSI design flow, and FIG. **4** shows a computer aided design (CAD) flow in the sixth embodiment. In the conventional design method, as shown in FIG. **5****,** after RTL design, the logic synthesis CAD program **502** is executed for the RTL file **501** as input data to generate the gate-level netlist **503.** The scan test circuit insertion CAD program **504** is then executed for the gate-level netlist **503** to generate the scan test circuit inserted netlist 505.

The scan test circuit inserted netlist **505** is used as input data for a mask layout CAD program **506.** Placement/wiring and then CTS insertion are performed under the mask layout CAD program **506,** and then clock delay analysis is performed under a clock delay analysis program **507.** Clock skew adjustment **508** is then performed using the analysis results, to output a netlist 409 and pattern information GDSII.

FIG. **4** shows an LSI design flow in the sixth embodiment. Referring to FIG **4****,** the process is substantially the same until the clock delay analysis **407** (or **507)** as that of the flow of FIG. **5** described above, except for the scan test circuit insertion program **404.** The flow in this embodiment is different from the flow of FIG. **5** largely in the following two points. First, a scan test circuit inserted netlist **405** is generated by the scan chain design method described in the first to fourth embodiments (or also in the fifth embodiment) under the scan test circuit insertion CAD program **404.** Second, optimization of the scan chain is also done with the algorithm described in the fourth embodiment in step **408** of adjusting clock skew using the results of the clock delay analysis 407.

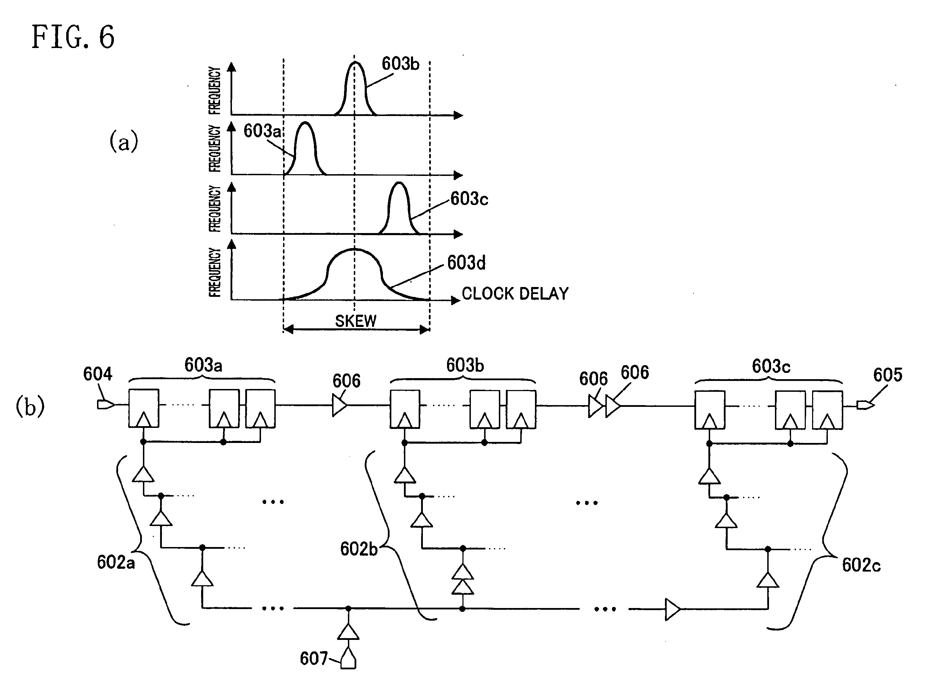

The scan chain optimization in the step **408** in the LSI design flow shown in FIG. **4** will be described with reference to FIG. 6.

In the clock delay analysis step **407** in FIG. **4****,** the clock delay in each sub-scan chain can be grasped, and based on this information, the clock delay difference between sub-scan chains is determined. An example of distribution of clock delays determined in the clock delay analysis step **407** is shown in FIG. **6A** as a frequency distribution **603d.** In FIG. **6A****,** three sub-scan chains **603a, 603b** and **603c** shown in FIG. **6B** are exemplified among a number of sub-scan chains. Clock tree buffers **602a, 602b** and **602c** are respectively provided for FF circuits constituting the three sub-scan chains **603a, 603b** and **603c,** forming a CTS circuit. Frequency distributions **603a** to **603c** in FIG. **6A** respectively correspond to the clock delay frequency distributions of the sub-scan chains **603a to 603c.**

In the sixth embodiment, the input of the sub-scan chain **603a** largest in clock delay distribution is connected to a scan-in terminal **604,** while the output of the sub-scan chain **603c** smallest in clock delay distribution is connected to a scan-out terminal **605.** Also, connection of sub-scan chains inside the LSI is done so that the sub-scan chains are rearranged in the descending order of the center value of the clock delay distribution. In other words, in this embodiment, the sub-scan chain **603b** middle in clock delay distribution is placed between the sub-scan chains **603a** and **603c.** Note that the reconnection is done with insertion of delay elements **606** for hold time guarantee.

Thus, in this embodiment, robust design against a variation in clock delay can be attained comparatively easily. Also, it is no more necessary to insert a number of delay elements for hold guarantee later indiscriminately, unlike the conventional scan design method. Accordingly, in the sixth embodiment, a scan test circuit permitting guarantee of scan shift operation with a considerably small number of delay elements, compared with the conventional design method, can be provided.

### (Seventh Embodiment)

In general, a scan test circuit includes no logic circuit between FF circuits in the scan shift circuit portion in many cases. Therefore, while a shift register has enough room in design limitations on the setup time, it has extremely little room in design limitations on the hold time in many cases. In the conventional scan test design, therefore, most commonly adopted is a method in which design guarantee on the hold time is secured by inserting buffers for hold guarantee in the data line in the scan shift-side circuit.

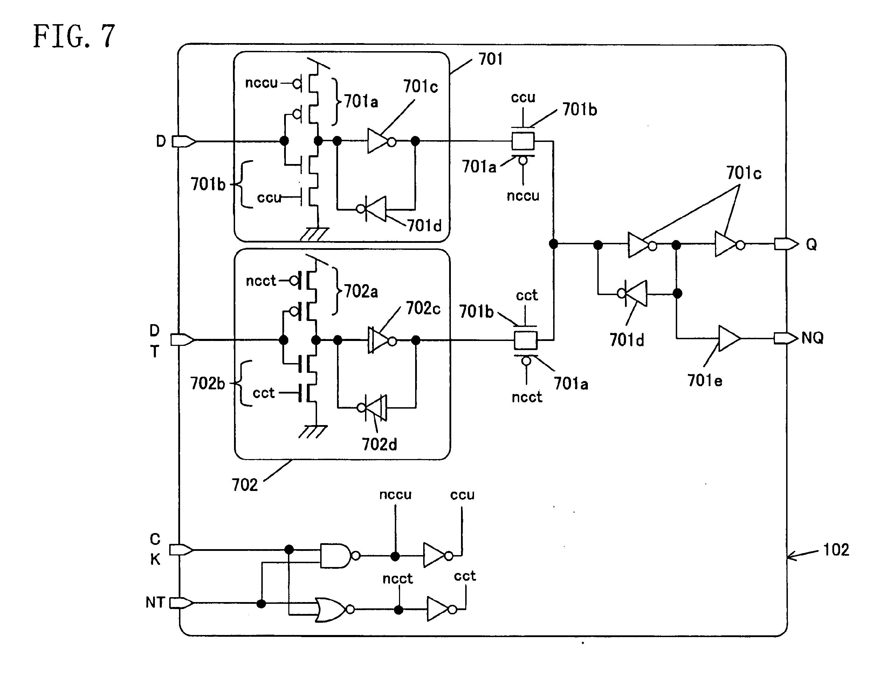

In the seventh embodiment of the present invention, provided are scan FF circuits that are unaffected by the setup time for data transfer between FF circuits in a normal circuit and do not cause increase in circuit area due to insertion of buffers for hold guarantee and the like. This embodiment will be described with reference to FIG. 7.

FIG. 7 shows an example of an FF circuit in the seventh embodiment. Referring to FIG. **7****,** a scan FF circuit **102** has a normal data input terminal D, a scan shift data input terminal DT, a clock terminal CK and a test mode terminal NT as the input terminals, and a pair of output terminals Q and NQ.

P-type transistors **702a,** N-type transistors **702b,** an inverter **702c** and a tri-state inverter **702d** constituting a scan shift data input-side circuit **702** located at the scan shift data input terminal DT are formed of transistors high in threshold voltage compared with transistors in the other portion of the FF circuit **102,** in particular, transistors of components **701a** to **701d** constituting a normal data input-side circuit **701** at the normal data input terminal D.

Accordingly, in the seventh embodiment, it is unnecessary to insert a delay circuit for hold time guarantee in the data line in the scan shift-side circuit, and thus the delay time on the scan shift data input side can be increased without increase in the area of the FF circuit.

As a result, since the number of delay elements inserted in the shift data lines for the scan FF circuits for hold guarantee at the time of scan shift design can be reduced, an LSI small in circuit area and power consumption can be provided.

### (Eighth Embodiment)

The eighth embodiment of the present invention will be described.

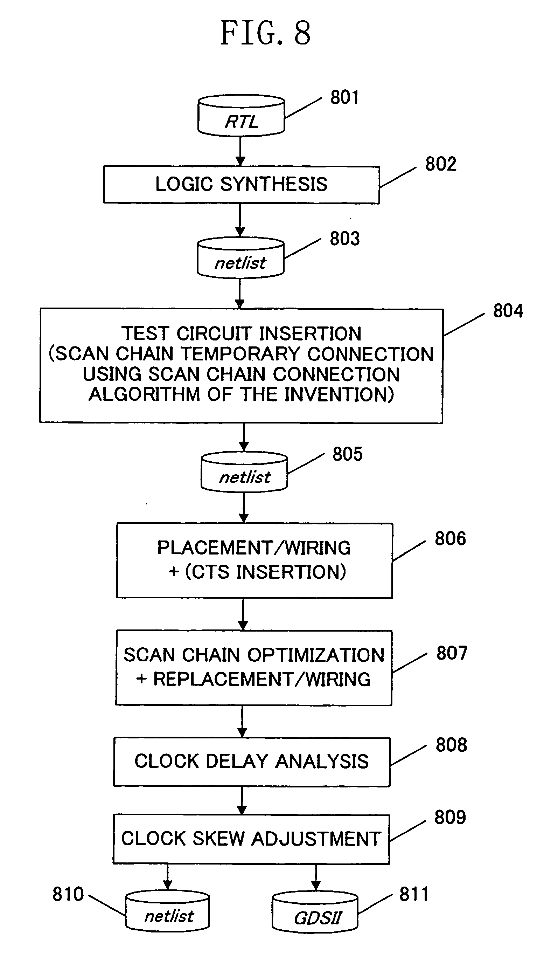

In the eighth embodiment, a design for testability (DFT) CAD program for executing the scan test design in the first to fourth and sixth embodiments will be described with reference to FIGS. **3** and **8**.

In the scan insertion CAD program as a conventional DFT design program, FF circuits are replaced with scan FF circuits, and the shift data input terminal of a scan FF circuit is randomly scan-cascaded to an output terminal of another scan FF circuit.

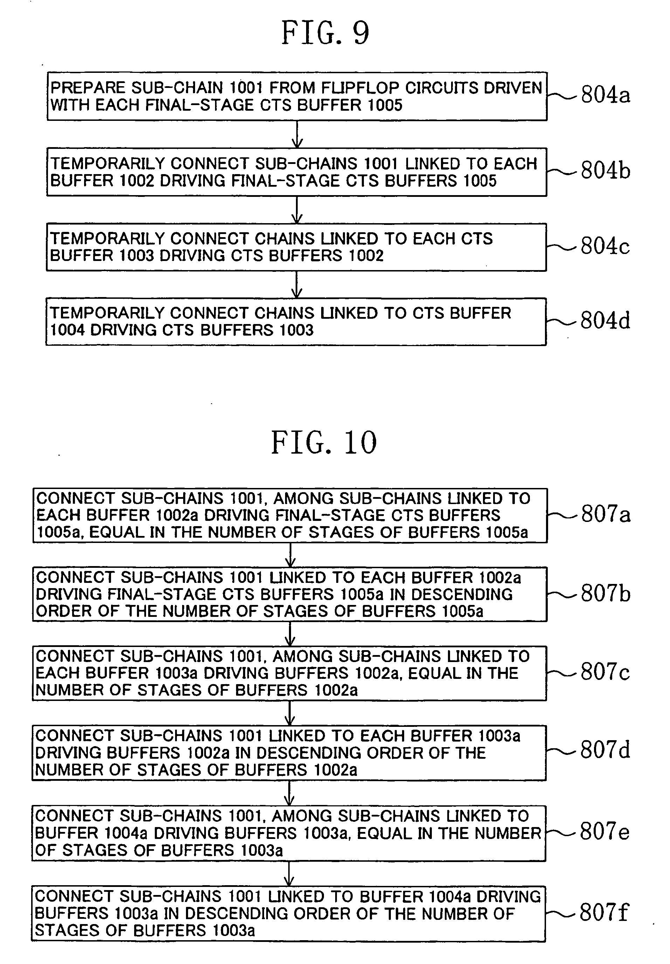

In a scan test circuit insertion CAD program in the eighth embodiment, as shown in FIG. **8****,** after RTL design, a logic synthesis CAD program **802** is executed for an RTL file **801** as input data to generate a gate-level netlist **803.** A scan test circuit insertion CAD program **804** is then executed for the gate-level netlist **803** to generate a scan test circuit inserted netlist **805.** FIG. **9** shows details of the scan test circuit insertion CAD program **804**.

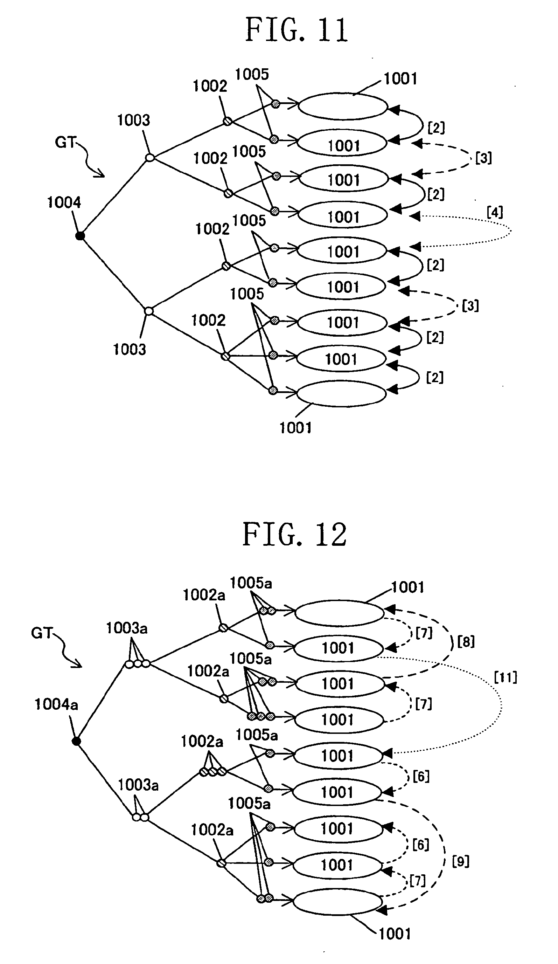

The scan test circuit insertion CAD program **804** of FIG. **9** will be described with reference to FIG. **11****.** First, in step **804a,** a sub-scan chain **1001** is formed from FF circuits driven with each final-stage CTS buffer **1005.** Thereafter, in step **804b,** sub-scan chains **1001** linked to each of CTS buffers **1002** driving the final-stage buffers **1005** are temporarily connected to each other (shown by **[2]** in FIG. **11**)**.** In step **804c,** sub-scan chains **1001** linked to each of a plurality of CTS buffers **1003** driving the CTS buffers **1002** are temporarily connected to each other (shown by **[3]** in FIG. **11**). Finally, in step **804d,** sub-scan chains **1001** linked to a first-stage CTS buffer **1004** driving the CTS buffers **1003** are temporarily connected to each other (shown by **[4]** in FIG. **11**).

Referring back to FIG. **8****,** in the step **806,** placement/wiring and then CTS insertion are performed under the mask layout CAD program.

Subsequently, in step **807,** circuit information on the portion of shift data transfer between **FF** circuits constituting the scan shift register is temporarily cut, and netlist information on part of the scan shift register is reset. Thereafter, a netlist is reconfigured with the algorithm described in the first to sixth embodiments based on the number of stages of CTS buffers and the number of stages of elements of the clock circuit. A CAD program for reconfiguring the netlist is shown in FIG. **10****.** Using the new gate-level netlist in which the scan shift register-side circuit has been optimized, re-layout (relocation/wiring) or only wiring is performed.

The netlist reconfiguration program of FIG. **10** will be described with reference to FIG. **12****.** Referring to FIG. **10****,** first, in step **807a,** sub-scan chains **1001,** among the sub-scan chains **1001** linked to each of CTS buffers **1002a** driving final-stage buffers **1005a,** equal in the number of stages of CTS buffers **1005a** are connected to each other (shown by **[6]** in FIG. **12**). Thereafter, in step **807b,** sub-scan chains **1001** linked to each CTS buffer **1002a** driving final-stage buffers **1005a** are connected to each other so that connection be made from a sub-scan chain **1001** larger in the number of stages of CTS buffers **1005a** to a sub-scan chain **1001** smaller in the number of stages (shown by **[7]** in FIG. **12**). In step **807c,** sub-scan chains **1001,** among the sub-scan chains **1001** linked to each CTS buffer **1003a** driving a plurality of CTS buffers **1002a,** equal in the number of stages of CTS buffers **1002a** are connected to each other (shown by **[8]** in FIG. **12**). Thereafter, in step **807d,** sub-scan chains **1001** linked to each CTS buffer **1003a** driving a plurality of CTS buffers **1002a** are connected to each other so that connection be made from a sub-scan chain **1001** larger in the number of stages of CTS buffers **1002a** to a sub-scan chain **1001** smaller in the number of stages (shown by **[9]** in FIG. **12**). In step **807e,** sub-scan chains **1001,** among the sub-scan chains **1001** linked to a CTS buffer **1004a** driving a plurality of CTS buffers **1003a,** equal in the number of stages of CTS buffers **1003a** are connected to each other (none applies in FIG. **12**). And finally, in step **807f,** sub-scan chains **1001** linked to the CTS buffer **1004a** driving a plurality of CTS buffers **1003a** are connected to each other so that connection be made from a sub-scan chain **1001** larger in the number of stages of CTS buffers **1003a** to a sub-scan chain **1001** smaller in the number of stages (shown by **[11]** in FIG. 12).

Thereafter, referring back to FIG. **8**, clock delay analysis is performed in step **808**. In step **809**, CTS adjustment (clock skew adjustment) is performed, and also optimization of partial placement and physical wiring is performed again under the mask layout CAD program. As a result, obtained are netlist data **810** and pattern information **GDSII** in which the shift register circuit portion has been reconfigured.

Thus, in the eighth embodiment, a design for testability (DFT) CAD program for implementing the scan test design described in the first to fourth and sixth embodiments can be provided.

### (Ninth Embodiment)

The ninth embodiment of the present invention will be described.

The ninth embodiment provides a DFT design CAD program for implementing the scan test design described in the first to fourth and sixth embodiments, and a mask layout CAD program having a function of optimizing scan chains. This will be described with reference to FIGS. **3** and 4.

In the scan insertion CAD program as a conventional DFT design program, FF circuits are replaced with scan FF circuits, and scan cascading is made randomly between shift data input terminals and output terminals of the scan FF circuits.

As shown in FIG. **4****,** in the scan insertion CAD program in the ninth embodiment, after RTL design, the logic synthesis CAD program **402** is executed for the RTL file **401** as the input data to generate the gate-level netlist **403.** The scan test circuit insertion CAD program **404** is then executed for the gate-level netlist **403** to generate the scan test circuit inserted netlist **405.** The details of the scan test circuit insertion CAD program **404** are as shown in FIG. **9** described above, and thus description thereof is omitted here.

Thereafter, in the step **406** shown in FIG. **4**, wiring is made under the conventional mask layout CAD program, and CTS is inserted. In the step **407**, clock delay analysis is performed. In the step **408**, clock skew adjustment is performed based on the results of the clock delay analysis. Subsequently, information on connection between FF circuits on the scan shift side is temporarily cut, and part of netlist information is reset. Thereafter, a netlist is reconfigured with the algorithm described in the first to sixth embodiments based on the number of stages of CTS buffers and the number of stages of elements of the clock circuit or clock delay information on sub-scan chains, using the CAD program in the ninth embodiment. In the step **408**, also, physical wiring is executed again for the new scan shift-side circuit under the mask layout CAD program, using the new gate-level netlist in which the scan shift-side circuit has been optimized. The scan chain optimization CAD program in the step **408** is substantially the same as the CAD program shown in FIG. **10**, except that the point of execution of the program is after the clock skew adjustment performed based on the results of the clock delay analysis. Therefore, description on this program is omitted here.

As a result, the CAD program in the ninth embodiment outputs a netlist and mask layout data in which the shift circuit portion has been reconfigured.

### (Tenth Embodiment)

The tenth embodiment of the present invention will be described.

In the first embodiment, a scan shift register was formed from FF circuits driven with the same final-stage CTS element as the minimum unit. In the tenth embodiment, provided is a method in which a sub-scan chain is formed from FF circuits grouped by a net serving as the start point of execution of gated CTS and terminals as the minimum unit for a CTS-gating circuit.

As a method permitting implementation of a low-power circuit, a design method using clock gating is known. Some CAD tool has a function of automatically establishing CTS even when a gated circuit exists in a clock line. In this case, in principle, high-precision skew adjustment has often been made from the net as the start point of execution of gated CTS up to the clock terminals of FF circuits. Accordingly, in combining the present invention with such a design method, a sub-scan chain may be formed from FF circuits connected to the part of the clock tree downstream of the base point of execution of gated CTS as the minimum unit. The scan test design described above can also be applied to this case.

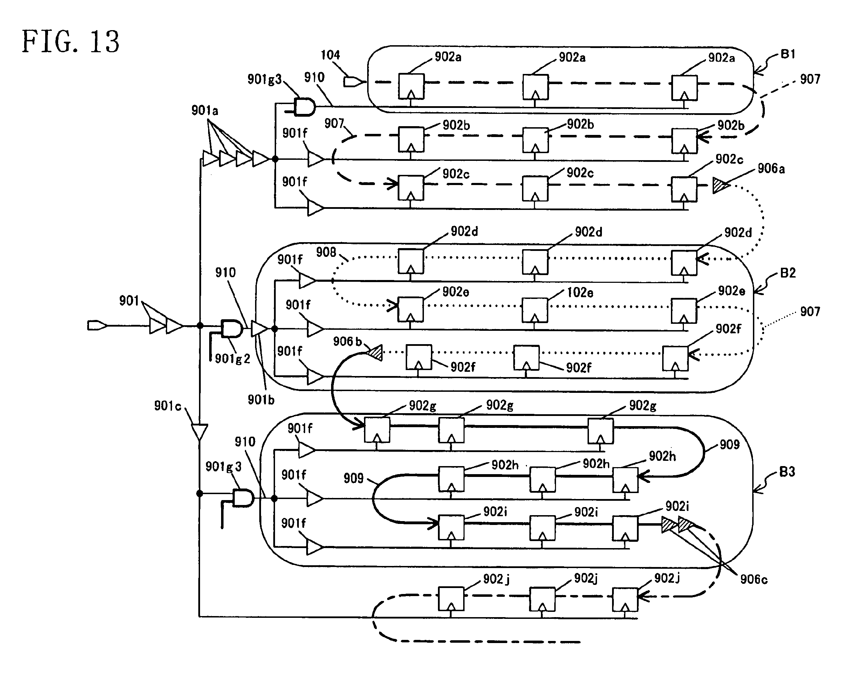

A method for forming a sub-scan chain with gated CTS described above will be described with reference to FIG. **13**. Referring to FIG. **13**, in a gated clock tree GS, first, second and third gating elements (clock gate elements) **901g1**, **901g2** and **901g3** are placed. The first gating element **901g1** is connected to clock terminals of three scan flipflop circuits **902a** belonging to a first block **B1** on the top. The second gating element **901g2** is connected to clock terminals of nine scan flipflop circuits **902d**, **902e** and **902f** belonging to a second block **B2** in the middle. The third gating element **901g3** is connected to clock terminals of nine scan flipflop circuits **902g**, **902h** and **902i** belonging to a third block **B3** on the bottom. The gating elements **901g1** to **901g3** halt supply of the clock signal to the flipflop circuits belonging to the corresponding blocks **B1** to **B3** when a common or individual condition is satisfied, to thereby achieve low power.

Further, in the respective blocks **B1** to **B3,** the flipflop circuits therein are placed at positions closer to one another so as to minimize power required for clock supply from the corresponding gating elements **901g1** to **901g3.** Therefore, the flipflop circuits belonging to the same block are roughly the same in the value of the propagation delay time of the clock signal from the corresponding gating element **901g1, 901g2** or **901g3.** In view of this, in this embodiment, the plurality of flipflop circuits belonging to the same block are connected in series, to thereby form one sub-scan shift register for each of the blocks **B1** to **B3**.

In FIG. **13**, the same connection method as that described in the second embodiment shown in FIG. **1** is adopted for connection between sub-scan shift registers in each of these blocks and between these sub-scan shift registers and sub-scan shift registers composed of other flipflop circuits.

In the case of gated CTS, portions equivalent in the number of stages of elements of the clock tree and in circuit configuration are few in number in not a few cases. Therefore, it is desirable to combine this method with the sixth embodiment in which scan chain optimization is attempted by use of the results of the clock delay analysis after CTS insertion.

The scan test circuits and the design methods thereof according to the present invention were described. Any of such scan test circuits may be put together with an internal circuit of which operation is tested with the scan test circuit, to form a large-scale integrated circuit, and further portable digital equipment having such a large-scale integrated circuit may be produced. Since the scan test circuit described above is a low-power circuit, a large-scale integrated circuit and digital equipment having a long battery life can be implemented.

### INDUSTRIAL APPLICABILITY

As described above, according to the present invention, design guarantee for the operation of a scan shift register can be easily secured, and the number of delay elements for hold guarantee inserted in a shift data transfer line can be reduced. Therefore, the present invention is applicable to scan test design methods, scan test circuits and scan test circuit insertion programs, which realize robust design permitting little design reversion, improvement in the convergence of the timing characteristic and satisfactory guarantee of the scan shift operation, and also to large-scale integrated circuits and the like provided with such scan test circuits, used for portable digital equipment and the like.

## Claims

1. A computer implemented scan test design method for testing a semiconductor integrated circuit, comprising the steps of:
a) providing a number of scan flipflop circuits (102) as a scan test circuit;
b) providing a clock tree (T) being formed for clock terminals of the scan flipflop circuits;
c) connecting in series a plurality of scan flipflop circuits driven with each of the final-stage elements (101f) located at the final stage of the clock tree, to form a scan shift register for each final-stage element, regarded as a sub-scan chain, and
d) connecting such sub-scan chains to each other to form a longer scan shift register,
**characterized by**
a step e) wherein, when said sub-scan chains differ in the number of stages of elements constituting the clock tree, sub-scan chains equal in the number of stages of elements (101) constituting the clock tree are connected (107, 108, 109) to each other first.

2. The scan test design method of Claim 1, wherein when sub-scan chains different in the number of stages of elements constituting the clock tree are to be connected to each other, in the next step following the steps of claim 1, sub-scan chains smallest in a relative difference in the number of stages of elements constituting the clock tree are connected (110, 111) to each other.

3. The scan test design method of Claim 2, wherein, when sub-scan chains different in the number of stages of elements constituting the clock tree are connected to each other, a delay element (106) of the number determined in advance according to the difference in the number of stages of elements constituting the clock tree is inserted between the sub-scan chains connected to each other.

4. The scan test design method of Claim 1, 2 or 3, wherein the sub-scan chains are connected so that data transfer be made from a sub-scan chain (603a) longer in a delay time from a clock origin point of the clock tree up to the clock terminals of the flipflop circuits constituting the sub-scan chain to a sub-scan chain (603c) shorter in the delay time.

5. The scan test design method of claim 1 or 2, wherein the semiconductor integrated circuit also has a gated clock tree with clock gate elements (901 g) placed at a plurality of predetermined positions of the clock tree, and a plurality of scan flipflops driven with each of the clock gate elements are connected in series, to form a scan shift register for each clock gate element.

6. The scan test design method of Claim 1, 2, 3, or 4, wherein the scan test design method is executed for the semiconductor integrated circuit according to claim 5.

7. A scan test circuit for testing a semiconductor integrated circuit, comprising:
a plurality of scan flipflop circuits (102);
a clock tree (T) being formed for clock terminals of the plurality of scan flipflop circuits (102); and
scan shift registers formed from a plurality of flipflop circuits connected to the final-stage element (101f), for each of a plurality of final-stage elements located at the tail ends of the clock tree, whereby the scan shift registers are regarded as sub-chains and at least two flipflop circuits equal in the number of stages of elements (101) of the clock tree from a predetermined clock supply point (S) of the clock tree up to the clock terminals of the flipflop circuits, among the plurality of scan flipflop circuits, are connected to each other sequentially, to form the scan shift register
**characterized in that**
sub-scan chains equal in the number of stages of elements (101) constituting the clock tree are connected to each other (107, 108, 109), the circuit being adapted such that, when said sub-scan chains differ in the number of stages of elements constituting the clock tree, sub-scan chains equal in the number of stages of elements are connected to each other first.

8. The scan test circuit of Claim 7, wherein as for flipflop circuits different in the number of stages of elements of the clock tree from the predetermined clock supply point of the clock tree up to the clock terminals of the flipflop circuits, flipflop circuits smallest in a relative difference in the number of stages of elements of the clock tree from the predetermined clock supply point of the clock tree up to the clock terminals of the flipflop circuits are connected to each other sequentially(110, 111), to make the scan shift register longer.

9. The scan test circuit of Claim 7, wherein delay elements (106) are placed between the scan shift registers, and the scan shift registers are connected to each other via the delay elements to form a long shift register.

10. The scan test circuit of Claim 9, each of the delay circuits is composed of a transistor (702) having a threshold voltage higher than a threshold voltage of transistors constituting the flipflop circuits.

11. A scan test design method for testing a semiconductor integrated circuit, comprising the steps of:
a) executing a logic synthesis CAD program (802) for an RTL file (801) as input data to generate a gate-level netlist (803);
b) executing a scan test circuit insertion CAD program (804) for the gate-level netlist (803) to generate a scan test circuit inserted netlist (805), thereby performing method steps a - d of claim 1;
c) performing placement/wiring (806) and then clock tree synthesis insertion (806);
d) temporarily cutting circuit connection in a shift data transfer portion between the scan flipflop circuits in the circuit data and resetting netlist information on part of the scan shift register (807);
e) optimizing a scan chain (807a, c, e) by performing method steps b - e of claim 1; and
f) outputting netlist information (807).

12. The scan test design method of Claim 11, wherein, when performing the method step e of claim 1, a subsequent step of giving priority to connection between sub-scan chains smallest in a relative difference in the number of stages of elements constituting the clock tree is executed.

13. A scan test circuit insertion CAD comprising computer program code means adapted to perform all the steps of the methods of claim 11 or 12.

14. A large-scale integrated circuit comprising the scan test circuit of Claim 8 and an internal circuit to be tested by the scan test circuit.

15. Portable digital equipment incorporating the large-scale integrated circuit of Claim 14.

## Patentansprüche

1. Computerimplementiertes Scan-Test-Designverfahren zum Testen einer integrierten Halbleiterschaltung, das die folgenden Schritte umfasst:
a) Bereitstellen einer Anzahl von Scan-Flipflop-Schaltungen (102) als eine Scan-Test-Schaltung;
b) Bereitstellen eines Taktverteilungsbaums (clock tree) (T), der für Taktanschlüsse der Scan-Flipflop-Schaltungen ausgebildet ist;
c) Verbinden einer Vielzahl von Scan-Flipflop-Schaltungen, die mit jedem der Endstufenelemente (101f) angesteuert werden, die sich auf der Endstufe des Taktverteilungsbaums befinden, in Reihe, um ein Scan-Schieberegister für jedes Endstufenelement auszubilden, das als eine Neben-Scan-Kette betrachtet wird, und
d) Verbinden dieser Neben-Scan-Ketten miteinander, um ein längeres Scan-Schieberegister auszubilden,
**gekennzeichnet durch**
einen Schritt e), in dem, wenn sich die Neben-Scan-Ketten hinsichtlich der Anzahl von Stufen von Elementen unterscheiden, die den Taktverteilungsbaum bilden, Neben-Scan-Ketten, die die gleiche Anzahl von Stufen von Elementen (101) haben, die den Taktverteilungsbaum bilden, zuerst miteinander verbunden werden (107, 108, 109).

2. Scan-Test-Designverfahren nach Anspruch 1, wobei, wenn Neben-Scan-Ketten, die sich hinsichtlich der Anzahl von Stufen von Elementen unterscheiden, die den Taktverteilungsbaum bilden, miteinander verbunden werden, in dem nächsten Schritt nach den Schritten von Anspruch 1, Neben-Scan-Ketten, die die geringste relative Differenz hinsichtlich der Anzahl von Stufen von Elementen aufweisen, die den Taktverteilungsbaum bilden, miteinander verbunden werden (110, 111).

3. Scan-Test-Designverfahren nach Anspruch 2, wobei, wenn Neben-Scan-Ketten, die sich hinsichtlich der Anzahl von Elementen unterscheiden, die den Taktverteilungsbaum bilden, miteinander verbunden werden, ein Verzögerungselement (106) der Zahl, die im Voraus entsprechend der Differenz hinsichtlich der Anzahl von Stufen von Elementen bestimmt wird, die den Taktverteilungsbaum bilden, zwischen die miteinander verbundenen Neben-Scan-Ketten eingefügt wird.

4. Scan-Test-Designverfahren nach Anspruch 1, 2 oder 3, wobei die Neben-Scan-Ketten so verbunden sind, dass Datenübertragung von einer Neben-Scan-Kette (603a), die eine längere Verzögerungszeit von einem Takt-Ursprungspunkt des Taktverteilungsbaums aufweist, bis zu den Taktanschlüssen der Flipflop-Schaltungen, die die Neben-Scan-Kette bilden, zu einer Neben-Scan-Kette (603) durchgeführt wird, deren Verzögerungszeit kürzer ist.

5. Scan-Test-Designverfahren nach Anspruch 1 oder 2, wobei die integrierte Halbleiterschaltung des Weiteren einen Gatter-Taktverteilungsbaum mit Takt-Gatterelementen (901 g) aufweist, die an einer Vielzahl vorgegebener Positionen des Taktverteilungsbaums angeordnet sind, und eine Vielzahl von Scan-Flipflops, die mit jedem der Takt-Gatterelemente angesteuert werden, in Reihe verbunden sind, um ein Scan-Schieberegister für jedes Takt-Gatterelement zu bilden.

6. Scan-Test-Designverfahren nach Anspruch 1, 2, 3 oder 4, wobei das Scan-Test-Designverfahren für die integrierte Halbleiterschaltung nach Anspruch 5 durchgeführt wird.

7. Scan-Test-Schaltung zum Testen einer integrierten Halbleiterschaltung, die umfasst:
eine Vielzahl von Scan-Flipflop-Schaltungen (102);
einen Taktverteilungsbaum (T), der für Taktanschlüsse der Vielzahl von Scan-Flip-flop-Schaltungen (102) ausgebildet ist; und
Scan-Schieberegister, die aus einer Vielzahl von Flipflop-Schaltungen bestehen, die mit dem Endstufenelement (101f) für jedes einer Vielzahl von Endstufenelementen verbunden sind, die sich an den hinteren Enden des Taktverteilungsbaums befinden, wobei die Scan-Schieberegister als Nebenketten betrachtet werden und wenigstens zwei Flipflop-Schaltungen, die die gleiche Anzahl von Stufen von Elementen (101) des Taktverteilungsbaums von einem vorgegebenen Taktzuführpunkt (S) des Taktverteilungsbaums bis zu den Taktanschlüssen der Flipflop-Schaltungen von der Vielzahl der Scan-Flipflop-Schaltungen aufweisen, sequenziell miteinander verbunden werden, um das Scan-Schieberegister auszubilden,
**dadurch gekennzeichnet, dass**
Neben-Scan-Ketten mit gleicher Anzahl an Stufen von Elementen (101), die den Taktverteilungsbaum bilden, miteinander verbunden sind (107, 108, 109), wobei die Schaltung so eingerichtet ist, dass, wenn sich die Neben-Scan-Ketten hinsichtlich der Anzahl von Stufen von Elementen unterscheiden, die den Taktverteilungsbaum bilden, Neben-Scan-Ketten mit gleicher Anzahl an Stufen von Elementen zuerst miteinander verbunden werden.

8. Scan-Test-Schaltung nach Anspruch 7, wobei, bezüglich Flipflop-Schaltungen, die sich hinsichtlich der Anzahl an Stufen von Elementen des Taktverteilungsbaums von dem vorgegebenen Taktzuführpunkt des Taktverteilungsbaums bis zu den Taktanschlüssen der Flipflop-Schaltungen unterscheiden, Flipflop-Schaltungen mit einer kleinsten relativen Differenz hinsichtlich der Anzahl von Stufen von Elementen des Taktverteilungsbaums von dem vorgegebenen Taktzuführpunkt des Taktverteilungsbaums bis zu den Taktanschlüssen der Flipflop-Schaltungen sequenziell miteinander verbunden werden (110, 111), um das Scan-Schieberegister zu verlängern.

9. Scan-Test-Schaltung nach Anspruch 7, wobei Verzögerungselemente (106) zwischen den Scan-Schieberegistem angeordnet sind und die Scan-Schieberegister über die Verzögerungselemente miteinander verbunden sind, um ein langes Schieberegister auszubilden.

10. Scan-Test-Schaltung nach Anspruch 9, wobei jede der Verzögerungsschaltungen aus einem Transistor (702) mit einer Schwellenspannung besteht, die höher ist als eine Schwellenspannung von Transistoren, die die Flipflop-Schaltungen bilden.

11. Scan-Test-Designverfahren zum Testen einer integrierten Halbleiterschaltung, das die folgenden Schritte umfasst:
a) Ausführen eines Logiksynthese-CAD-Programms (802) für eine RTL-Datei (801) als Eingangsdaten, um eine Gatterebenen-Netzliste (Gate-level netlist) (803) zu erzeugen;
b) Ausführen eines Scan-Test-Schaltungsbestückungs-CAD-Programms (804) für die Gatterebenen-Netzliste (803), um eine Netzliste (805) mit bestückter Scan-Test-Schaltung zu erzeugen, um so die Verfahrensschritte a-d von Anspruch 1 durchzuführen;
c) Durchführen von Anordnung/Verdrahtung (806) und anschließend Zuführung von Taktverteilungsbaum-Synthese-Bestückung (806);
d) temporäres Trennen von Schaltungsverbindung in einem Schiebe-Datenübertragungsabschnitt zwischen den Scan-Flipflop-Schaltungen in den Schaltungsdaten und Zurücksetzen von Netzlisten-Informationen über einen Teil des Scan-Schieberegisters (807);
e) Optimieren einer Scan-Kette (807a, c, e) durch Durchführen von Verfahrensschritten b-e nach Anspruch 1; und
f) Ausgeben von Netzlisten-Informationen (807).

12. Scan-Test-Designverfahren nach Anspruch 11, wobei beim Durchführen des Verfahrensschritts e) nach Anspruch 1 ein anschließender Schritt ausgeführt wird, mit dem Verbindung zwischen Neben-Scan-Ketten mit der kleinsten relativen Differenz hinsichtlich der Anzahl von Stufen von Elementen, die den Taktverteilungsbaum bilden, Priorität verliehen wird.

13. Scan-Test-Schaltungsbestückungs-CAD, das Computerprogramm-Codemittel umfasst, die zum Durchführen aller Schritte der Verfahren nach Anspruch 11 oder 12 eingerichtet sind.

14. Hochintegrierte Schaltung, die die Scan-Test-Schaltung nach Anspruch 8 und eine interne Schaltung umfasst, die mit der Scan-Test-Schaltung zu testen ist.

15. Tragbares digitales Gerät, das die hochintegrierte Schaltung nach Anspruch 14 enthält.

## Revendications

1. Procédé de conception d'essais de balayage mis en oeuvre par ordinateur pour soumettre un circuit intégré à semi-conducteur à des essais, comprenant les étapes de:
a) prévoir un nombre de circuits à bascules de balayage (102) en tant que circuit d'essais de balayage;
b) prévoir un arbre d'horloge (T) qui est formé pour des bornes d'horloge des circuits à bascules de balayage;
c) connecter en série plusieurs circuits à bascules de balayage pilotés avec chacun des éléments de l'étage final (101f) situés à l'étage final de l'arbre d'horloge, afin de former un registre à décalage de balayage pour chaque élément de l'étage final, considérés comme une chaîne de sous-balayage, et
d) connecter de telles chaînes de sous-balayage les unes aux autres afin de former un registre à décalage de balayage plus long
**caractérisé par**
une étape e) dans laquelle, lorsque lesdites chaînes de sous-balayage ont un nombre différent d'étages d'éléments constituants l'arbre d'horloge, des chaînes de sous-balayage d'un nombre identique d'étages d'éléments (101) constituants l'arbre d'horloge sont d'abord connectées (107, 108, 109) entre elles.

2. Procédé de conception d'essais de balayage de la revendication 1, dans lequel lorsque des chaînes de sous-balayage d'un nombre différent d'étages d'éléments constituants l'arbre d'horloge doivent être connectées entre elles, dans l'étape suivante venant après les étapes de la revendication 1, des chaînes de sous-balayage les plus petites dans une différence relative du nombre d'étages d'éléments constituants l'arbre d'horloge sont connectées (110, 111) entre elles.

3. Procédé de conception d'essais de balayage de la revendication 2, dans lequel, lorsque des chaînes de sous-balayage d'un nombre différent d'étages d'éléments constituants l'arbre d'horloge doivent être connectées entre elles, un élément de retard (106) du nombre déterminé en avance selon la différence du nombre d'étages d'éléments constituants l'arbre d'horloge est inséré entre les chaînes de sous-balayage connectées entre elles.

4. Procédé de conception d'essais de balayage de la revendication 1, 2 ou 3, dans lequel les chaînes de sous-balayage sont connectées de sorte qu'un transfert de données soit exécuté d'une chaîne de sous-balayage (603a) plus longue dans un temps de retard d'un point d'origine d'horloge de l'arbre d'horloge jusqu'aux bornes d'horloge des circuits à bascules constituant la chaîne de sous-balayage à une chaîne de sous-balayage (603c) plus courte dans le temps de retard.

5. Procédé de conception d'essais de balayage de la revendication 1 ou 2, dans lequel le circuit intégré à semi-conducteur possède également un arbre d'horloge à porte avec des éléments de porte d'horloge (901 g) placés à plusieurs positions prédéterminées de l'arbre d'horloge, et plusieurs bascules de balayage pilotées avec chacun des éléments de porte d'horloge sont connectées en série, afin de former un registre à décalage de balayage pour chaque élément de porte d'horloge.

6. Procédé de conception d'essais de balayage de la revendication 1, 2, 3, ou 4, dans lequel le procédé de conception d'essais de balayage est exécuté pour le circuit intégré à semi-conducteur selon la revendication 5.

7. Circuit d'essai de balayage pour soumettre un circuit intégré à semi-conducteur à des essais, comprenant:
plusieurs circuits à bascules de balayage (102);
un arbre d'horloge (T) qui est formé pour des bornes d'horloge des plusieurs circuits à bascules de balayage (102); et
des registres à décalage de balayage formés à partir de plusieurs circuits à bascules connectés à l'élément de l'étage final (101f), pour chacun d'une pluralité d'éléments d'étage final situés aux extrémités de queue de l'arbre d'horloge, de sorte que les registres à décalage de balayage sont considérés comme des sous-chaînes et au moins deux circuits à bascules ayant un nombre égal d'étages d'éléments (101) de l'arbre d'horloge à partir d'un point (S) d'alimentation prédéterminé de l'horloge de l'arbre d'horloge jusqu'aux bornes d'horloge des circuits à bascules, parmi la pluralité de circuits à bascules de balayage, sont connectés entre eux de manière séquentielle, afin de former le registre à décalage de balayage,
**caractérisé en ce que**
des chaînes de sous-balayage ayant un nombre égal d'étages d'éléments (101) constituant l'arbre d'horloge sont connectées entre elles (107, 108, 109), le circuit étant adapté de sorte que, lorsque lesdites chaînes de sous-balayage ont des nombres différents d'étages d'éléments constituants l'arbre d'horloge, des chaînes de sous-balayage ayant un nombre égal d'étages d'éléments sont d'abord connectées entre elles.

8. Circuit d'essais de balayage de la revendication 7, dans lequel pour des circuits à bascules ayant des nombres différents d'étages d'éléments de l'arbre d'horloge à partir du point d'alimentation prédéterminé de l'horloge de l'arbre d'horloge jusqu'aux bornes d'horloge des circuits à bascules, des circuits à bascules les plus petits dans une différence relative du nombre d'étages d'éléments de l'arbre d'horloge à partir du point d'alimentation prédéterminé de l'horloge de l'arbre d'horloge jusqu'aux bornes d'horloge des circuits à bascules sont connectés entre eux de manière séquentielle (110, 111), afin de rendre le registre à décalage de balayage plus long.

9. Circuit d'essais de balayage de la revendication 7, dans lequel des éléments de retard (106) sont placés entre les registres à décalage de balayage, et les registres à décalage de balayage sont connectés entre eux par le biais des éléments de retard afin de former un registre à décalage long.

10. Circuit d'essais de balayage de la revendication 9, chacun des circuits de retard est composé d'un transistor (702) possédant une tension seuil plus élevée qu'une tension seuil de transistors constituant les circuits à bascules.

11. Procédé de conception d'essais de balayage pour soumettre un circuit intégré à semi-conducteur à des essais, comprenant les étapes de:
a) exécuter un programme de CAO à synthèse logique (802) pour un fichier RTL (801) comme données d'entrées afin de générer une liste d'interconnexions niveau porte (803);
b) exécuter un programme de CAO d'insertion de circuit d'essais de balayage (804) pour la liste d'interconnexions niveau porte (803) afin de générer une liste d'interconnexions à circuit d'essais de balayage inséré (805), exécutant ainsi les étapes a-d du procédé de la revendication 1;
c) exécuter un placement/câblage (806) et ensuite une insertion de synthèse d'arbre d'horloge (806);
d) couper temporairement une connexion de circuit dans une partie de transfert de données de décalage entre les circuits à bascules de balayage dans les données de circuits et réinitialiser une information de liste d'interconnexions sur une partie du registre à décalage de balayage (807);
e) optimiser une chaîne de balayage (807a, c, e) en exécutant les étapes b-e du procédé de la revendication 1; et
f) délivrer en sortie une information de liste d'interconnexions (807).

12. Procédé de conception d'essais de balayage de la revendication 11, dans lequel, lors de l'exécution de l'étape e du procédé de la revendication 1, une étape subséquente consistant à donner la priorité à la connexion entre des chaînes de sous-balayage les plus petites dans une différence relative du nombre d'étages d'éléments constituants l'arbre d'horloge est exécutée.

13. CAO d'insertion de circuit d'essais de balayage comprenant un moyen de code de programme d'ordinateur adapté pour exécuter toutes les étapes des procédés de la revendication 11 ou 12.

14. Circuit intégré à grande échelle comprenant le circuit d'essais de balayage de la revendication 8 et un circuit interne devant être soumis à un essai par le circuit d'essais de balayage.

15. Equipement numérique portatif incorporant le circuit intégré à grande échelle de la revendication 14.
